# EUROPÄISCHE PATENTSCHRIFT

(11) **EP 1 218 699 B1**
(45) Veröffentlichungstag und Bekanntmachung des Hinweises auf die Patenterteilung: **12.11.2003**
(21) Anmeldenummer: 00952941.3
(22) Anmeldetag: 21.07.2000
(51) Int. Cl.: G01D 4/02, G06M 3/06, G01F 15/00, G01F 15/06

(54) **VERBRAUCHSZÄHLER FÜR FLÜSSIGE UND GASFÖRMIGE MEDIEN**
SUPPLY METER FOR LIQUID AND GASEOUS MEDIUMS
COMPTEUR DE CONSOMMATION POUR SUBSTANCES LIQUIDES ET GAZEUSES

(30) Priorität: 18.09.1999 DE 19944788
(43) Veröffentlichungstag der Anmeldung: 03.07.2002
(73) Patentinhaber: Utility Consult Hinzmann & Koenig OHG, 20249 Hamburg (DE)
(72) Erfinder: KOENIG, Peter, Wilhelm, D-20249 Hamburg (DE); HINZMANN, Martin, 20354 Hamburg (DE)
(74) Vertreter: Pohl, Manfred, Dr.
(86) Internationale Anmeldenummer: DE0002375
(87) Internationale Veröffentlichungsnummer: WO01022036

(56) Entgegenhaltungen:
- EP-A- 0 124 434
- WO-A-99/30285
- US-A- 5 058 525
- US-A- 5 235 565

## Beschreibung

Die Erfindung betrifft einen Verbrauchszähler für flüssige oder gasförmige Medien oder elektrischen Strom, mit einer Anzeigeeinrichtung für die Menge des durch den Verbrauchszähler hindurchtretenden Mediums, die mit einem kumulierten Zählerstand den gesamten bisherigen Verbrauch anzeigt und die Wiedergabe eines Prüfcodes ermöglicht.

Ein derartiger Verbrauchszähler ist durch die DE 19623044 A1 bekannt. Dieser bekannte Verbrauchszähler arbeitet elektronisch und besitzt eine elektro-optische Anzeigevorrichtung zur Anzeige des Verbrauchswerts und eines Prüfcodes für den Verbrauch und eines Zustandsprüfcodes für den Verbrauchszähler. Dieser Verbrauchszähler ermöglicht eine nachprüfbare Auswertung der abgelesenen Verbrauchswerte und des Zustands des Verbrauchszählers. Zur Ablesung des Verbrauchszählers soll der Verbraucher bzw. Ablesepersonal sowohl den tatsächlichen als auch den codierten Anzeigewert auf eine Karte übertragen, die dann von dem Versorgungsunternehmen ausgewertet wird, wobei dieses die Richtigkeit der Ablesung durch Decodieren des codierten Anzeigewertes überprüfen kann. Aufgrund der konstruktiven Ausgestaltung und der erforderlichen elektronischen Baugruppen sind die Herstellkosten gegenüber mechanischen Verbrauchszählern jedoch wesentlich höher.

US-A-5 058 525 beschreibt einen Verbrauchszähler für die Anzeige des kumulierten Verbrauchs eines Mediums mit einem Prüfcode. Dabei dreht ein Zeiger, der nur auf eine Achse aufgesteckt ist, über eine Anzeigeskale. Um Betrug durch den Verbraucher nachweisen zu können, ist die Achse fest mit einer abgedeckten Codescheibe verbunden, so dass ein Verdrehen des Zeigers relativ zur Achse und damit auch relative zur Codescheibe nachweisbar und rekonstruierbar ist.

Die Aufgabe der Erfindung besteht darin, einen Verbrauchszähler der eingangs genannten Art so auszubilden, dass ohne elektronische Baugruppen Verbrauchsangaben sicher auszuwerten sind und die Überprüfung der Richtigkeit des abgelesenen Zählerstandes und von Geräteeigenschaften mittels eines Prüfcodes möglich ist.

Erfindungsgemäß erfolgt die Lösung der Aufgabe durch die kennzeichnenden Merkmale des Anspruchs 1. Vorteilhafte Ausgestaltungen der Erfindung werden in den abhängigen Ansprüchen beschrieben.

Der Verbrauchszähler nach der Erfindung hat eine mechanische Anzeige für die Menge des durch den Verbrauchszähler hindurchgetretenen Verbrauchsmediums, die mit einem kumulierten Zählerstand den gesamten bisherigen Verbrauch anzeigt und zusätzlich die Wiedergabe eines Prüfcodes ermöglicht. Die Generierung des Prüfcodes erfolgt durch mechanische Getriebe, deren Übersetzungsverhältnisse durch die Bauform bestimmt werden und von 1 : 10 abweichend sein können. Die Darstellung des Prüfcodes erfolgt auf Rollen oder Scheiben, deren Segmentzahl von 10 abweichen kann. Für die Darstellung des Prüfcodes können ferner Ziffern, Buchstaben, Zeichen oder Symbole vorgesehen werden. Erfolgt die Darstellung des Prüfcodes in Form von Ziffern oder Buchstaben, sind die Segmente der Rollen oder Scheiben nicht fortlaufend beschriftet, sondern zur Erschwerung von Manipulationen in einer abweichenden Reihenfolge, wie zum Beispiel "7, 2, 3, 1, 5, 9, 0, 4, 6, 8" oder "B, X, K, Z, D, A, L, O, E, F". Sofern zur Darstellung des Prüfcodes Buchstaben oder Symbole verwendet werden, stehen diese für bestimmte Zahlen, die als Information ausgewertet werden. Der Drehkörper der Prüfcodeanzeigeeinrichtung kann in beliebiger Stellung mit dem Getriebe der Verbrauchsanzeigeeinrichtung verbunden werden. Es wird nur jeweils die Anzeige der Prüfcodeanzeigeeinrichtung und der Gerätenummer in der Nullstellung der Verbrauchsanzeigeeinrichtung festgehalten, da diese Anzeige des Prüfcodes dann die Grundlage für die Auswertung später ermittelter Prüfcodedaten bildet. Hierbei wird das jeweils vorhandene Übersetzungsverhältnis zwischen dem Getriebe der Verbrauchsanzeigeeinrichtung und der Prüfcodiereinrichtung berücksichtigt. Dieses kann zum Beispiel 1 : 3,5 sein.

Die Erfindung wird nachstehend anhand des in der Zeichnung dargestellten Ausführungsbeispiels eines Verbrauchszählers näher erläutert. Es zeigt:

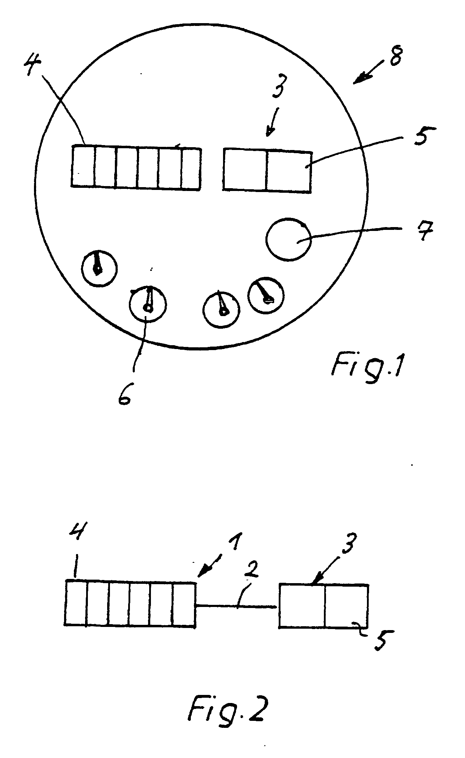

Fig. 1 eine Draufsicht auf die Anzeige des Verbrauchszählers,
Fig. 2 die schematische Verbindung von Verbrauchsanzeigeeinrichtung und Prüfcodeanzeigeeinrichtung.

Die Anzeige 8 des Verbrauchszähler weist eine numerische Verbrauchsanzeige 4 auf, die aus parallel zueinander angeordneten Walzen mit Zahlenaufdruck bestehen können. Parallel zu der numerischen Verbrauchsanzeige 4 ist eine Prüfcodeanzeige 5 angeordnet, die ebenfalls aus einer Walze besteht, auf der parallel zueinander Zahlen, Symbole, Buchstaben oder dergleichen angeordnet sind. Die Prüfcodeanzeige 5 kann mittels einer nicht näher dargestellten Abdeckung abgedeckt sein, die mittels eines Tasters 7 betätigbar ist. Vorzugsweise ist der Taster 7 gedämpft ausgebildet. Dies kann zum Beispiel durch eine Feder, ein Luftpolster oder ein Ölpolster erfolgen. Ferner weist die Anzeige 8 noch an sich bekannte Verbrauchsanzeigen 6 auf, mittels derer die jeweils verbrauchten Teilmengen des Mediums angezeigt werden.

Die Prüfcodeanzeigeeinrichtung 3 ist mittels eines Getriebeanschlussmittels 2 mit dem Getriebe 1 der Verbrauchsanzeigeeinrichtung starr verbunden. Das Übersetzungsverhältnis zwischen dem Getriebe 1 und der Prüfcodeanzeigeeinrichtung 3 kann frei gewählt werden und zum Beispiel 1 : 3,5 betragen. Die Bestimmung des Übersetzungsverhältnisses ist für die Auswertung des Prüfcodes wesentlich.

## Patentansprüche

1. Verbrauchszähler für flüssige oder gasförmige Medien oder elektrischen Strom, mit einer Anzeigeeinrichtung (4, 6) für die Menge des durch den Verbrauchszähler hindurchtretenden Mediums, die mit einem kumulierten Zählerstand den gesamten bisherigen Verbrauch anzeigt und die Wiedergabe eines Prüfcodes ermöglicht, **dadurch gekennzeichnet, dass** die Prüfcodeanzeigeeinrichtung (3) mechanisch mit dem Getriebe (1) der Verbrauchsanzeigeeinrichtung (4) verbunden und das Übersetzungsverhältnis zwischen dem Getriebe (1) und der Prüfcodeanzeigeeinrichtung (3) frei wählbar ist.

2. Verbrauchszähler nach Anspruch 1, **dadurch gekennzeichnet, dass** sich der von der Prüfcodeanzeigeeinrichtung (3) wiedergegebene Prüfcode aus der Stellung der Verbrauchsanzeigeeinrichtung (4), der Stellung der Prüfcodeanzeigeeinrichtung (3) in der Nullstellung der Verbrauchsanzeigeeinrichtung (4) und dem Übersetzungsverhältnis zwischen dem Getriebe (1) und der Prüfcodeanzeigeeinrichtung (3) ergibt.

3. Verbrauchszähler nach Anspruch 1 oder 2, **dadurch gekennzeichnet, dass** die Prüfcodeanzeigeeinrichtung (3) als Drehkörper ausgerichtet ist.

4. Verbrauchszähler nach Anspruch 3, **dadurch gekennzeichnet, dass** die Prüfcodeanzeigeeinrichtung (3) als Rollenanzeige ausgebildet ist.

5. Verbrauchszähler nach Anspruch 3, **dadurch gekennzeichnet, dass** die Prüfcodeanzeigeeinrichtung (3) als Scheibenanzeige ausgebildet ist.

6. Verbrauchszähler nach einem der Ansprüche 1 bis 5, **dadurch gekennzeichnet, dass** die Prüfcodeanzeigeeinrichtung (3) einen Prüfcode für den kumulierten Zählerstand anzeigt.

7. Verbrauchszähler nach einem der Ansprüche 1 bis 6, **dadurch gekennzeichnet, dass** die Prüfcodeanzeigeeinrichtung (3) in der Nullstellung der Verbrauchsanzeigeeinrichtung (4) festgehalten wird, um einen Teil der Gerätenummer zu generieren.

8. Verbrauchszähler nach einem der Ansprüche 1 bis 7, **dadurch gekennzeichnet, dass** die Prüfcodeanzeigeeinrichtung (3) den kumulierten Zählerstand und gerätespezifische Daten des Verbrauchszählers verschlüsselt anzeigt.

9. Verbrauchszähler nach Anspruch 8, **dadurch gekennzeichnet, dass** als gerätespezifische Daten Gerätenummer und/oder Gerätetyp angezeigt werden.

10. Verbrauchszähler nach einem der Ansprüche 1 bis 9, **dadurch gekennzeichnet, dass** die Prüfcodeanzeigeeinrichtung (3) den Prüfcode in Form von Buchstaben, Ziffern, Zahlen oder Symbolen anzeigt.

11. Verbrauchszähler nach einem der Ansprüche 1 bis 10, **dadurch gekennzeichnet, dass** mittels eines mechanischen Tasters (7) eine über der Anzeigefläche der Prüfcodeanzeigeeinrichtung (3) angeordnete Abdeckung betätigbar ist.

12. Verbrauchszähler nach Anspruch 11, **dadurch gekennzeichnet, dass** der Taster (7) gedämpft ist.

## Claims

1. Supply meter for liquid or gaseous media or electric current, with a display device (4, 6) for displaying the amount of the medium passing through the supply meter, which displays with a cumulative meter reading the entire amount consumed to date and makes possible the production of a verification code, **characterized in that** the verification code display device (3) is mechanically linked with the drive means (1) for the consumed-amount display device (4), and that the translation relationship between the drive means (1) and the verification code display device (3) is freely selectable.

2. Supply meter according to claim 1, **characterized in that** the verification code provided by the verification code display device (3) results from the position of the consumed-amount display device (4), the setting of the verification code display device (3) in zero position of the consumed-amount display device (4), and the translation relationship between the drive means (1) and the verification code display device (3).

3. Supply meter according to claim 1 or 2, **characterized in that** the verification code display device (3) is a rotating body.

4. Supply meter according to claim 3, **characterized in that** the verification code display device (3) is a rotating display.

5. Supply meter according to claim 3, **characterized in that** the verification code display device (3) is a disk display.

6. Supply meter according to one of claims 1 to 5, **characterized in that** the verification code display device (3) displays a verification code for the cumulative meter reading.

7. Supply meter according to one of claims 1 to 6, **characterized in that** the verification code display device (3) is recorded in the zero position of the consumed-amount display device (4), in order to generate a portion of the device number.

8. Supply meter according to one of claims 1 to 7, **characterized in that** the verification code display device (3) displays, encoded, the cumulative meter reading and device-specific data of the supply meter.

9. Supply meter according to claim 8, **characterized in that** as the device-specific data there is displayed the device number and/or device type.

10. Supply meter according to one of claims 1 to 9, **characterized in that** the verification code display device (3) displays the verification code in the form of letters, characters, numbers or symbols.

11. Supply meter according to one of claims 1 to 10, **characterized in that** a cover provided over the display surface of the verification code display device (3) is operable by means of a mechanical push button (7).

12. Supply meter according to claim 11, **characterized in that** the push button (7) is cushioned.

## Revendications

1. Compteur de consommation pour fluides liquides ou gazeux ou courant électrique, comportant un dispositif d'affichage (4, 6) pour la quantité de fluide traversant le compteur de consommation, qui affiche par un état cumulé du compteur la consommation totale jusqu'à ce jour et permet l'édition d'un code de contrôle, **caractérisé en ce que** le dispositif d'affichage du code de contrôle (3) est relié mécaniquement à l'organe de commande (1) du dispositif d'affichage de consommation (4) et que le rapport de transmission entre l'organe de commande (1) et le dispositif d'affichage du code de contrôle (3) peut être choisi librement.

2. Compteur de consommation selon la revendication 1, **caractérisé en ce que** le code de contrôle édité par le dispositif d'affichage du code de contrôle (3) résulte de la position du dispositif d'affichage de consommation (4), de la position du dispositif d'affichage du code de contrôle (3) en position zéro du dispositif d'affichage de consommation (4) et du rapport de transmission entre l'organe de commande (1) et le dispositif d'affichage du code de contrôle (3).

3. Compteur de consommation selon la revendication 1 ou 2, **caractérisé en ce que** le dispositif d'affichage du code de contrôle (3) est conçu sous forme d'un corps rotatif.

4. Compteur de consommation selon la revendication 3, **caractérisé en ce que** le dispositif d'affichage du code de contrôle (3) est conçu sous forme d'un afficheur à défilement.

5. Compteur de consommation selon la revendication 3, **caractérisé en ce que** le dispositif d'affichage du code de contrôle (3) est conçu sous forme d'un afficheur à disque.

6. Compteur de consommation selon l'une quelconque des revendications 1 à 5, **caractérisé en ce que** le dispositif d'affichage du code de contrôle (3) affiche un code de contrôle pour l'état cumulé du compteur.

7. Compteur de consommation selon l'une quelconque des revendications 1 à 6, **caractérisé en ce que** le dispositif d'affichage du code de contrôle (3) est maintenu dans la position zéro du dispositif d'affichage de consommation (4) afin de générer une partie du numéro d'appareil.

8. Compteur de consommation selon l'une quelconque des revendications 1 à 7, **caractérisé en ce que** le dispositif d'affichage du code de contrôle (3) affiche sous forme codée l'état cumulé et des données spécifiques à l'appareil du compteur de consommation.

9. Compteur de consommation selon la revendication 8, **caractérisé en ce que** s'affichent comme données spécifiques à l'appareil le numéro d'appareil et/ou le type d'appareil.

10. Compteur de consommation selon l'une quelconque des revendications 1 à 9, **caractérisé en ce que** le dispositif d'affichage du code de contrôle (3) affiche le code de contrôle sous forme de lettres alphabétiques, chiffres, nombres ou symboles.

11. Compteur de consommation selon l'une quelconque des revendications 1 à 10, **caractérisé en ce qu'**on peut actionner au moyen d'une touche mécanique (7) un capot disposé au dessus de la surface d'affichage du dispositif d'affichage du code de contrôle (3).

12. Compteur de consommation selon la revendication 11, **caractérisé en ce que** la touche (7) est amortie.
